Europäisches Patentamt

European Patent Office

Office européen des brevets

(19)

(11)   EP 0 752 531 B2

(12)   **NEUE EUROPÄISCHE PATENTSCHRIFT**

(45) Veröffentlichungstag und Bekanntmachung des Hinweises auf die Entscheidung über den Einspruch:
**18.06.2003  Patentblatt 2003/25**

(45) Hinweis auf die Patenterteilung:
**04.11.1998  Patentblatt 1998/45**

(21) Anmeldenummer: **96108037.1**

(22) Anmeldetag: **21.05.1996**

(51) Int Cl.[7]: **F04B 37/14**, F04B 49/00, F04C 29/10

(54) **Vorrichtung zum raschen Evakuieren einer Vakuumkammer**

Apparatus for rapid evacuation of a vacuum chamber

Appareil pour l'obtention rapide du vide dans une chambre à vide

(84) Benannte Vertragsstaaten:
**BE CH DE ES FR GB IT LI LU NL SE**

(30) Priorität: **06.07.1995  DE 19524609**

(43) Veröffentlichungstag der Anmeldung:
**08.01.1997  Patentblatt 1997/02**

(73) Patentinhaber: **Balzers und Leybold Deutschland Holding Aktiengesellschaft**
**63450 Hanau (DE)**

(72) Erfinder:
• **Gebele, Thomas**
  **63579 Freigericht (DE)**
• **Buschbeck, Wolfgang**
  **63454 Hanau (DE)**

(74) Vertreter: **Schlagwein, Udo, Dipl.-Ing. Patentanwalt,**
**Frankfurter Strasse 34**
**61231 Bad Nauheim (DE)**

(56) Entgegenhaltungen:
**EP-A- 0 166 851          EP-A- 0 510 656**
**EP-A- 0 541 989          DD-A- 96 304**
**DD-A- 118 144            DD-A- 200 534**
**DE-A- 2 462 187          DE-A- 3 639 512**
**DE-B- 1 024 668          DE-B- 1 114 981**
**DE-T- 68 906 869         US-A- 2 652 188**
**US-A- 5 042 521**

• **Füssel, U.: Trockenlaufende Vakuumpumpen in der chemischen Industrie; Vakuum in der Praxis 1994, Nr. 2, Seiten 85 - 88**

Printed by Jouve, 75001 PARIS (FR)

## Beschreibung

Die Erfindung betrifft eine Vorrichtung, gemäß dem Oberbegriff des Anspruches 1 wie diese z.B. in Dokument DE-A-3639512 illustriert ist.

Zum schnellen Evakuieren großer Volumina werden häufig Pumpstände mit voreinlaßgekühlten Wälzkolbenpumpen eingesetzt. Bei Kammern, die in den Druckbereich unterhalb 200 mbar abgepumpt werden sollen, haben sich mehrstufige Pumpenstationen bewährt. Bekannt ist, als größte, direkt an der Väkuumkammer angeordnete Pumpe ein Wälzkolbenpumpe einzusetzen und für die nachgeschaltete Pumpstufe eine beliebige Kombination aus voreinlaßgekühlten Wälzkotbenpumpen und/oder anderen Pumpen zu wählen. Zum Abpumpen wird dann die größte voreinlaßgekühlte Wälzkolbenpumpe auf die Vakuumkammer geschaltet. Damit ergibt sich schon ab Atmosphärendruck ein großes Saugvermögen. Durch diese Vorgehensweise können die nachgeschalteten (kleineren) Pumpen die von der ersten Pumpe geförderte Gasmenge nicht mehr bei Drücken unter Atmosphärendruck fördern. Um hier den Aufbau eines unerwünschten Überdrucks zu verhindern, wird üblicherweise zwischen der ersten und der zweiten Pumpstufe eine Ausblasklappe zur Atmosphäre eingebaut. Abhängig von der Abstufung der verwendeten Pumpen ergibt sich ein Übernahmedruck, ab dem die Ausblasklappe schließt, weil die Vorpumpen jetzt den von der ersten Stufe geförderten Massenstrom im Unterdruckbereich fördern können. Erst unterhalb des Übernahmedrucks hat der Vorpumpstand einen Einfluß auf das Gesamtsaugvermögen. Bei höheren Drücken bleibt der Vorpumpstand also ungenutzt.

In der DE AS 1 024 668 ist ein mehrstufiges Hochvakuumpumpsystem mit einer Hochvakuumpumpe und einer Vorvakuumpumpe zum Absaugen von Dämpfen beschrieben. Zum Absaugen der Dämpfe aus einem zu evakuierenden Vakuumraum sind die Pumpen zunächst parallel geschaltet. Sobald ein Vakuum von etwa 80% in dem zu evakuierenden Vakuumraum erreicht ist, werden die Pumpen hintereinander geschaltet.

Der vorliegenden Erfindung liegt nun die Aufgabe zugrunde, die Hauptpumpe und die Vorpumpe so miteinander zu kombinieren, daß die Pumpzeit verkürzt wird.

Diese Aufgabe wird gelöst durch eine Vorrichtung gemäß dem Oberbegriff des Anspruchs 1 mit den weiteren Merkmalen,

dass in dem ersten Schritt der Pumpsequenz außerdem das erste Absperrventil geöffnet ist, so dass sich das Saugvermögen beider Pumpen addiert,

dass eine in die Verbindungsleitung in dem Leitungsabschnitt zwischen dem zweiten Absperrventil und dem Druckstutzen der ersten Pumpe eingeschaltete, in die Atmosphäre einmündende Ausblasklappe vorgesehen ist

und dass der zweite Schritt eingeleitet wird, wenn ein Druck unterhalb eines Übernahmedruckes vorliegt, wobei der Übernahmedruck derjemige ist, bei dem die Ausblasklappe schließt.

Die Erfindung läßt die verschiedensten Ausführungsmöglichkeiten zu; eine davon ist in der anhängenden Zeichnung schematisch dargestellt, und zwar zeigen:

Figur 1: eine Vorrichtung mit Hauptpumpe und Vorpumpe nach dem Stand der Technik und

Figur 2: eine Vorrichtung nach der Erfindung mit Pumpen, die sowohl in Reihe als auch parallel schaltbar sind.

Figur 3: die in Figur 2 dargestellte Vorrichtung mit Voreinlaßleitung.

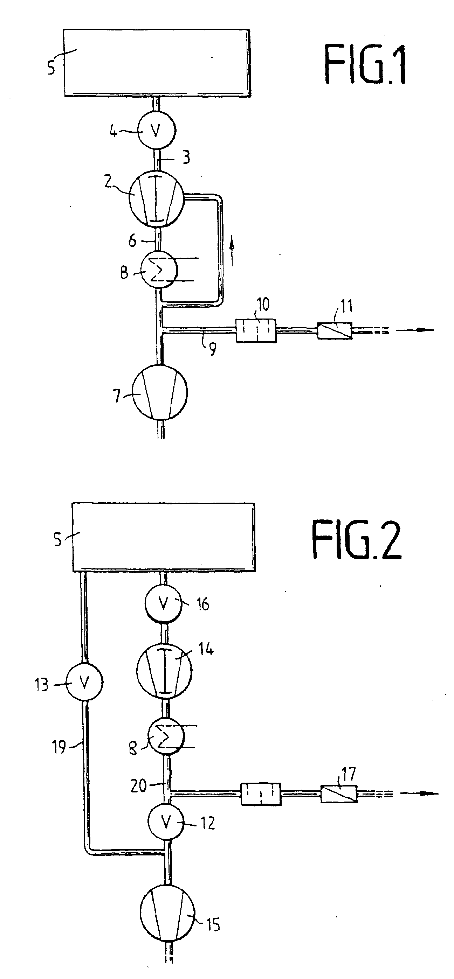

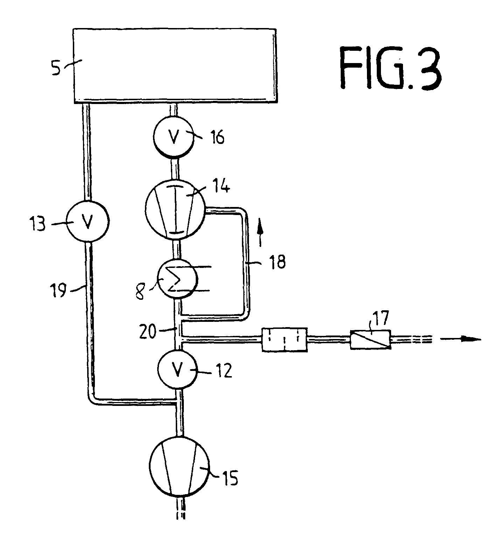

Bei der Vorrichtung nach Figur 1 ist die Hauptpumpe als Wälzkolbenpumpe 2 ausgebildet und über den Saugstutzen 3 mit in diesen eingeschaltetem Absperrventil 4 an die Vakuumkammer 5 angeschlossen, während der Druckstutzen der Pumpe 2 über die Verbindungsleitung 6 an die Vorpumpe 7 angeschlossen ist. In die Verbindungsleitung 6 sind außerdem ein Voreinlaßkühler 8 und in eine Zweigleitung 9 ein Schalldämpfer 10 und eine Ausblasklappe 11 eingeschaltet. Über die Voreinlaßleitung 18 kann, um eine zu starke Erwärmung der Pumpe 2 (siehe Fig. 1 und Fig. 3) zu unterbinden, das durch den Voreinlaßkühler 8 abgekühlte, gepumpte Gasmedium zur Kühlung der Pumpe 2 in diese rückgeführt werden. Da die beiden Pumpen 2 und 7 hintereinander geschaltet sind, ist die Vorschaltpumpe 7 zu Beginn des Evakuierungsvorgangs wirkungslos.

Das Ziel der Erfindung ist es, das Saugvermögen der Vorpumpen 7 auch bei Drücken oberhalb des Übernahmedruckes zur Evakuierung zu verwenden. Dies erfolgt durch die zusätzlichen Ventile 12 und 13. Dadurch ist es möglich, den Vorpumpenstand bei Drukken über dem Übernahmedruck - wenn er wegen der Ausblasklappe 11 bzw. 17 normalerweise keine Funktion hat - direkt auf den Vakuumkessel 5 zu schalten. In diesem Zeitraum steht jetzt nicht nur das Saugvermögen der Pumpe 2 bzw. 14, sondern noch zusätzlich das Saugvermögen des Vorpumpstands 7 bzw. 15 zur Verfügung: Pumpsequenz:

- Zum Pumpen werden die Ventile 16 und 13 gleichzeitig geöffnet, 12 bleibt geschlossen. Die Pumpen 14 und 15 evakuieren parallel die Vakuumkammer 5. Das Saugvermögen beträgt:

$$S = S(14) + S(15).$$

Die Pumpe 14 bläst die geförderte Gasmenge direkt über die Ausblasklappe 17 gegen die Atmosphäre aus.

- Bei einem geeignet zu wählenden Druck unterhalb des Übernahmedrucks wird das in die Nebenleitung 19 eingeschaltete Ventil 13 geschlossen und das in die Verbindungsleitung 20 eingeschaltete Ventil 12 geöffnet. Die Pumpe 15 dient jetzt als Vorpumpe für 14 und fördert den gesamten von 15 angesaugten Gasstrom.

Durch die beschriebene Maßnahme ist je nach Abstufung und gewünschtem Enddruck eine Verkürzung der Pumpzeit um 10-15% ohne zusätzliche Pumpe möglich.

**Bezugszeichenliste**

2       Wälzkolbenpumpe
3       Saugstutzen
4       Absperrventil
5       Vakuumkammer
6       Verbindungsleitung
7       Vorpumpe
8       Voreinlaßkühler
9       Zweigleitung
10      Schalldämpfer
11      Ausblasklappe
12      Ventil
13      Ventil
14      Pumpe
15      Pumpe
16      Ventil
17      Ausblasklappe
18      Voreinlaß, Umgehungsleitung

**Patentansprüche**

1.  Vorrichtung zum raschen Evakuieren einer Vakuumkammer (5) in zwei Schritten einer Pumpsequenz bestehend

    aus einer **ersten Vakuumpumpe** (14), vorzugsweise einer Wälzkolbenpumpe, aus einem die Saugseite dieser ersten Pumpe (14) mit der Vakuumkammer (5) verbindenden Saugstutzen, mit einem in diesen eingeschalteten **ersten Absperrventil** (16),

    einer der ersten Pumpe (14) nachgeschalteten **zweiten Vakuumpumpe** (15) mit einem in die die beiden Pumpen (14, 15) miteinander verbindende Leitung (20) eingeschalteten **zweiten Absperrventil** (12),

    einer an die Saugseite der zweiten Pumpe (15) an den Leitungsabschnitt zwischen der zweiten Pumpe (15) und dem zweiten Absperrventil (12) angeschlossenen und mit einer ein zwischengeschaltetes **drittes Absperrventil** (13) aufweisenden, in die Vakuumkammer (5) **einmündenden Nebenleitung** (19), wobei

die Vorrichtung darauf eingerichtet ist, dass

    in einem ersten Schritt der Pumpsequenz das zweite Absperrventil (12) geschlossen und das dritte Absperrventil (13) geöffnet ist, so dass der Saugstutzen der zweiten Pumpe (15) mit der Vakuumkammer (5) verbunden ist,

    und in einem zweiten Schritt der Pumpsequenz das erste Absperrventil (16) geöffnet, das zweite Absperrventil (12) geöffnet und das dritte Absperrventil (13) geschlossen ist, so dass die zweite Pumpe (15) als Vorpumpe für die erste Pumpe (14) eingesetzt ist,

**dadurch gekennzeichnet,**
    **dass** die Vorrichtung darauf eingerichtet ist, dass in dem ersten Schritt der Pumpsequenz außerdem das erste Absperrventil (16) geöffnet ist, so dass sich das Saugvermögen beider Pumpen addiert,
    **dass** eine in die Verbindungsleitung (20) in dem Leitungsabschnitt zwischen dem zweiten Absperrventil (12) und dem Druckstutzen der ersten Pumpe (14) eingeschaltete, in die Atmosphäre einmündende Ausblasklappe (17) vorgesehen ist
    und **dass** die Vorrichtung darauf eingerichtet ist, dass der zweite Schritt eingeleitet ist, wenn ein Druck unterhalb eines Übernahmedruckes vorliegt, wobei der Übernahmedruck derjemige ist, bei dem die Ausblasklappe (17) schließt.

**Claims**

1.  Device for the rapid evacuation of a vacuum chamber (5) in two stages of a pump sequence consisting of

    a first vacuum pump (14), preferably a rolling piston pump, a suction socket connecting the suction side of this first pump (14) to the vacuum chamber (5) with a first shut-off valve (16) inserted in this suction socket,

    a second vacuum pump (15), connected downstream of the first pump (14) with a second shut-off valve (12) installed in the line (20) connecting the two pumps (14, 15) to one another,

    an auxiliary line (19) connected to the suction side of the second pump (15) at the line section between the second pump (15) and the second shut-off valve (12), the said auxiliary line terminating in the vacuum chamber (5) and having an interconnected third shut-off valve (13), wherein

the device is designed so that

in a first stage of the pump sequence the second shut-off valve (12) is closed and the third shut-off valve (13) is open so that the suction socket of the second pump (15) is connected to the vacuum chamber (5),

and in a second stage of the pump sequence the first shut-off valve (16) is open, the second shut-off valve (12) is open and the third shut-off valve (13) is closed, so that the second pump (15) is used as a preliminary pump for the first pump (14), **characterised in that** the device is designed so that, in the first stage of the pump sequence, the first shut-off valve (16) is also open so that the suction capability of both pumps is combined, that a blow-off flap (17) is provided that is installed in the connection line (20) in the line section between the second shut-off valve (12) and the pressure connection member of the first pump (14) and opens into the atmosphere, and that the device is designed so that the second stage is initiated when a pressure below a takeover pressure exists, wherein the takeover pressure is that pressure at which the blow-off flap (17) closes.

**Revendications**

1. Dispositif pour mettre rapidement sous vide une chambre à vide (5), en deux étapes d'une séquence de pompe, constitué

d'une première pompe à vide (14), de préférence d'une pornpe Roots, d'une tubulure d'admission qui relie le côté admission de cette première pompe (14) avec la chambre à vide (5),avec une première vanne d'obturation (16) montée sur cette dernière, d'une seconde pompe à vide (15), montée en aval de la première pompe (14), avec une seconde vanne d'obturation (12) montée sur la conduite (20) qui relie l'une à l'autre les deux pompes (14, 15), d'une conduite de dérivation (19) reliée, du côté admission de la seconde pompe (15), au tronçon de conduits situé entre la seconde pompe (15) et la seconde vanne d'obturation (12), et qui présente une troisième vanne d'obturation (13) montée en position intermédiaire et qui débouche dans la chambre à vide (5),
le dispositif étant conçu de telle façon que

dans une première étape de la séquence des pompes, la seconde vanne d'obturation (12) est fermée et la troisième vanne d'obturation (13) est ouverte, de sorte que la tubulure d'admission de la seconde pompe (15) est reliée à la chambre à vide (5) et dans une deuxième étape de la séquence des pompes, la première vanne d'obturation (16) est ouverte, la seconde vanne d'obturation (12) est ouverte et la troisième vanne d'obturation (13) est fermée, de sorte que la seconde pompe (15) est utilisée comme prépompe pour la première pompe (14),

**caractérisé en ce que**
le dispositif est conçu de façon que, dans la première étape de la séquence des pompes, la première vanne d'obturation est en outre ouverte de sorte que le pouvoir d'aspiration des deux pompes s'additionne, il est prévu un clapet de vidange (17) intercalé dans la conduite de liaison (20), dans le tronçon de la conduit situé ente la seconde vanne d'obturation (12) et la tubulure de la première pompe (14), et débouchant dans l'atmosphère et le dispositif est conçu de façon que la deuxième étape est mise en oeuvre en présence d'un pression inférieure à la pression de transfert, la pression de transfert étant celle à laquelle se forme le clapet de vidange.

FIG.1

FIG.2

5

FIG.3